# EUROPEAN PATENT SPECIFICATION

(11) **EP 3 182 036 B1**
(45) Date of publication and mention of the grant of the patent: **11.08.2021**
(21) Application number: 16204126.3
(22) Date of filing: 14.12.2016
(51) Int. Cl.: F25B 9/10, F25B 9/14, F25D 19/00, H01F 6/04

(54) **METHOD OF ACCELERATING COOL DOWN**
VERFAHREN ZUR BESCHLEUNIGTEN ABKÜHLUNG
PROCÉDÉ D'ACCÉLÉRATION DE REFROIDISSEMENT

(30) Priority: 14.12.2015 GB 201521946
(43) Date of publication of application: 21.06.2017
(73) Proprietor: Oxford Instruments Nanotechnology Tools Limited, Oxon OX13 5QX (GB)
(72) Inventor: CLARKE, Neil, Oxon, OX13 5QX (GB)
(74) Representative: Gill Jennings & Every LLP

(56) References cited:
- DE-C1- 19 954 077
- US-A- 5 647 218
- US-A1- 2010 113 282
- US-B1- 6 813 892

## Description

### Field

The present invention relates to a method of cooling a cryogenic system. In particular, the present invention relates to a method of cooling a cryogenic system using multiple stages of cooling.

### Background

Cryogenic systems, such as MRI (Magnetic Resonance Imaging) systems, require the superconducting magnets they contain to be cooled to make them operational. To make the superconducting magnets function, they need to be cooled to extremely low temperatures. For example, this can be to less than 20 Kelvin (K).

It is possible to cool cryogenic systems using cryogens such as liquid Nitrogen or liquid Helium. However, in some circumstances, it is either not possible to use cryogens, or it is undesirable to do so. In such cases, it is possible to use other methods or devices that use less cryogen material, or no cryogens at all. For example, this may be done by using a cryocooler, such as pulse-tube refrigerator (PTR), GM-refrigerator, sterling refrigerator or another kind of cryocooler.

Cryocoolers work by directly cooling a target, e.g. a superconducting magnet, through thermal conduction. In order to cool to the required temperature, it is often necessary to use a two-stage cryocooler. This is because a single-stage cryocooler is often unable to cool to the required temperature.

However, because cryocoolers (including two-stage cryocoolers) are only capable of 'spot cooling', it can take two to three days to cool a target member, and for larger systems it may take two or more weeks to cool the target to an operating temperature. This therefore represents a significant period of time in which the cryogenic system is not operational. This means that a significant period of time during either the testing or installation of a cryogenic system must be set aside for cooling to the operational temperature. This is both inefficient and costly, as no use can be made of a cryogenic system and no testing can be conducted until it reaches its operational temperature. As such, there is a need to reduce the amount of time taken to cool a cryogenic system to an operational temperature so that an operational state is arrived at faster.

US 5647218 A discloses a cooling apparatus comprising a main refrigerator having a refrigerant-filled chamber, a sub-refrigerator connected parallel to the main refrigerator and having a refrigerant-filled chamber, switch control means for controlling the switching operation between the supply of a refrigerant used in the main refrigerator to the sub-refrigerator, and the stop of the supply of the refrigerant, on the basis of predetermined conditions.

DE 19954077 C1 discloses a low temperature cooling device that has a pulse tube cooler with a cold head providing a given temperature, which is coupled to a regenerator and a second pulse tube cooler with a cold head which provides a higher temperature and which is thermically coupled to the first pulse tube cooler and/or the regenerator via a heat switch.

US 6813892 B1 discloses a pulse tube cryocooler having a second cryocooler section with a single pulse tube stage, and having a first cryocooler section with a pair of pulse tube stages. A first pressure oscillator is associated with the first cryocooler section, while a second pressure oscillator is associated with the second cryocooler section. The first cryocooler section and the second cryocooler section are fluidly isolated from each other.

### Summary of Invention

According to the invention, there is provided a method of accelerating cool down of a target member of a cryogenic system to a cryogenic operating temperature as defined in claim 1. The method comprises the steps: cooling a target region of a cryogenic system with a first cooling apparatus, the first cooling apparatus being adapted to cool the target region to a first temperature by thermal conduction between the first apparatus and the target member, and having a first cooling power at the first temperature; cooling the target member of the cryogenic system from the first temperature to an operating temperature using a cryocooler, wherein the first cooling power of the first cooling apparatus at the first temperature is greater than the cooling power of the cryocooler at the first temperature. The first temperature may be a higher temperature than an equilibrium or sustainable temperature reachable by the first cooling apparatus (i.e. a base temperature). In such a case, cooling to the base temperature slows as the temperature approaches the base temperature.

The exact temperature of the first temperature will depend on the cooling apparatus that is used. For instance, an example first cooling apparatus may have a cooling power of approximately 65W at 30K and yet 0W at 20K, so it would be more efficient to start cooling with the cryocooler at a higher temperature than 20K due to the slowdown in cooling as the target region approaches 20K. The optimum point to begin cooling may be when the target region has been cooled to a temperature at which the cryocooler has a cooling power at least as high as (e.g. greater than or equal to) the cooling power of the first cooling apparatus at that temperature.

A practical consideration is that below approximately 80K, air will condense on surfaces should a swap of the first cooling apparatus and the cryocooler be attempted. It would therefore be beneficial to perform such a swap at slightly higher temperatures to reduce the risk of contamination.

Since the first cooling apparatus has a greater cooling power at the first temperature than the cryocooler, this makes the initial cooling more rapid than if only the cryocooler were used. Once the initial cooling is complete and the first temperature is attained by the target member, the cryocooler is then used to cool from the first temperature to the operating temperature, at which, for example, the cryocooler may have either a greater cooling power than the first cooling apparatus or the first cooling apparatus maybe incapable of achieving the operational temperature. We have found that cooling in this manner greatly increases the speed in which a cryogenic system, in particular the target member, is cooled. Using this method, the time taken to cool down a cryogenic system is able to be at least halved in many cases. For example, should a system take two weeks to cool down using conventional methods, using the method of the present invention, this would (depending on the exact circumstances) take around one week. Essentially, this method allows a target member of a cryogenic system to be cooled more rapidly than when conventional methods are used.

The target member of a cryogenic system is usually enclosed by one or more radiation shields, which are in turn contained within the body of a cryostat of the cryogenic system. As such for a device such as a cryocooler to be able to cool the target member by thermal conduction, it may be necessary to have an interface in the cryogenic system that provides a port into which a cooling element of the cryocooler may be placed. The cryogenic system may have two such interfaces, enabling the first cooling apparatus and the cryocooler to be attached thereto simultaneously at the separate interfaces. This would allow all cooling to be conducted without the need to remove one cooling device and replace it with a second cooling device. However, the method includes the step of replacing the first cooling apparatus with the cryocooler when the target region is at the first temperature. This means that the cryogenic system does not need to be specially adapted to allow this method to be performed, which means it can be used with any conventional cryogenic system that is able to be cooled by means of a cryocooler.

Conventionally, a cryogenic system may have at least one radiation shield. Each radiation shield provides insulation for the target member that it protects by effectively intercepting some of the heat transmitted from outside of the cryogenic system, which is likely to be at room temperature. This slows the rate at which a target of cooling is heated by the environment in which the cryogenic system is located. In order for the radiation shield(s) to be effective, each radiation shield needs to be cooled so as to place the target member in a low thermal radiation environment. The cooling of each radiation shield may be independent of the cooling of the target member. In practice when cooling the target member it is preferred that, the first cooling apparatus also cools at least one radiation shield by thermal conduction, the at least one radiation shield being located between the target member and an exterior of the cryogenic system. Furthermore, the first cooling apparatus also cools the at least one radiation shield by thermal conduction. Cooling any radiation shields simultaneously, with the same piece(s) of equipment allows greater efficiency in cooling and reduces the amount of equipment needed to cool the entire system, as well as the target member.

The cryocooler may be a single-stage cryocooler, but typically, the cryocooler is a two-stage cryocooler. This allows lower temperatures to be reached by the cryocooler, and allows for more efficient cooling at low temperatures. This is because the second stage of the cryocooler will be optimised to function most efficiently at low temperatures, such as 4K or 4.2K, which allows for more rapid cooling at such temperatures.

The first cooling apparatus may be any device capable of cooling to cryogenic temperatures by thermal conduction, such as a pipe or heat exchanger through which liquid helium is pumped. Typically, the first cooling apparatus is a single-stage cryocooler. A single-stage cryocooler allows predictable cooling of the target member, and is a single device that does not require significant amounts of cryogenic fluids. The advantage of using a single-stage cryocooler and then a two-stage cryocooler over just using a two-stage cryocooler is that the second stage of a two-stage cryocooler has limited cooling power at intermediate temperatures (for example at temperatures above approximately 25K to 40K), and so the ability of a two-stage cryocooler to cool a target member from room temperature down to a low operational temperature of 4K is very limited. A single-stage cryocooler is much more effective at cooling to such an intermediate temperature. This is because the single-stage cryocooler may be optimised to cool at, for example, 77K. This therefore increases the speed at which the target member is cooled by increasing the rate of initial cooling (that is from ambient temperature to the intermediate temperature, which acts as the "first temperature").

The single-stage cryocooler is coupled to the target member to allow thermal conduction between the single-stage cryocooler and the target member. This may be by a copper strip for example, or another thermally conductive material.

The cooling power of a cryocooler is usually affected by its dimensions as well as a number of other factors. "Off the shelf" single-stage cryocoolers are typically shorter than two-stage cryocoolers. This means that to cool a target region as efficiently as possible, some form of thermal coupling is used to bridge the gap between the single-stage cryocooler and the target region.

There may be two points that are being cooled, a target region and a radiation shield around the target region. To cool these two points, a single-stage cryocooler may be placed in direct contact with a radiation shield whilst a base of the single-stage cryocooler is thermally coupled to the target region. Therefore, the difference in length of a single-stage and a two-stage cryocooler means that when a two-stage cryocooler is used in place of the single-stage cryocooler, the first stage can be placed in direct contact with a radiation shield, whilst the second stage is placed in direct contact with the target region.

Alternatively, the first cooling apparatus includes a conduit and a heat exchanger and wherein a cooling fluid is provided to the heat exchanger through the conduit from an external cooling apparatus. The heat exchanger and external cooling apparatus provides an alternative to the single-stage cryocooler whilst also providing the benefits of the single-stage cryocooler in terms of greater cooling power at the first temperature.

### Brief Description of Figures

Embodiments are described in detail below with reference to the drawings, in which;
Fig. 1 shows a flow diagram of the process of an embodiment;
Fig. 2 shows a sectional view of a single-stage cryocooler coupled to a target member; and
Fig. 3 shows a sectional view of a two-stage cryocooler coupled to a target member.

### Detailed Description

Cryogenic systems, such as MRI systems, are transported around the world from their manufacturer to wherever they are needed. When such systems are fabricated, the manufacturer needs to test the system to ensure that if functions as expected. Upon arrival, a cryogenic system also needs to be made operational as soon as possible so that it can be made use of. Both testing and operation require the cryogenic system to be cooled to its operating temperature. It is desirable to cool the system as quickly as possible to allow the completion of testing or the system to be put to work as soon as possible. Due to the length of time needed for transportation of such cryogenic systems, it is not always possible to cool the system before transport and for it to still be cool on arrival.

However, due to the size of such cryogenic systems, which may have a mass that needs cooling in excess of 500kg, cooling such a system takes a significant period of time with all the known methods.

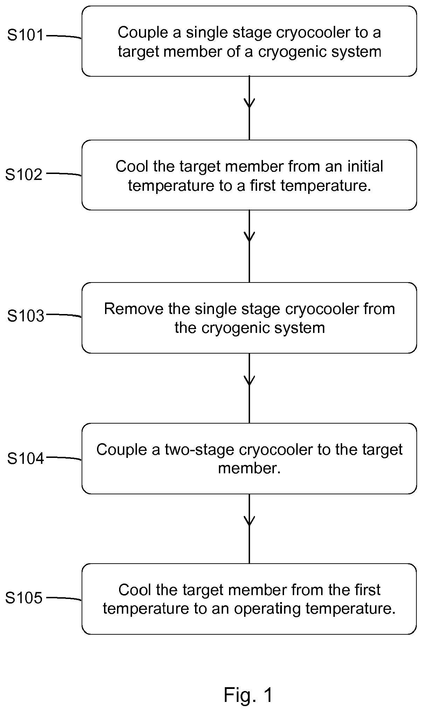

In order to shorten the time taken to cool a cryogenic system, a method in accordance with the process shown in Fig. 1 is used. A cryogenic system that requires cooling will have a housing in the form of a cryostat that surrounds one or more radiation shields, each of which insulate and isolate the volume contained within that radiation shield from the external environment. The radiation shield(s) encloses a cooling target (i.e. a target member), such as a superconducting magnet.

Historically, the target member of a cryogenic system has previously been maintained at its operational temperature by immersion in a bath of cryogen, such as liquid helium. However, cryogens, in particular liquid helium, are becoming more expensive because the supply is decreasing. Furthermore, there are situations in which using cryogens is undesirable. So, it is now possible to cool cryogenic systems using little or no cryogenic fluid. This is achieved by using a cooling apparatus such as a cryocooler.

When using cryocoolers, to be able to cool a cryogenic system, in particular the target member, a cryogenic system must have an interface to which such a cryocooler can be engaged. The interface includes a port through which the cooling elements of the cryocooler are able to be placed. The port extends from the exterior of the cryogenic system to the target member. This allows a cryocooler to be coupled to the target member, i.e. to be engaged with the target member in a thermally conductive relationship. The port also allows the cryocooler to be coupled to any radiation shields in the cryogenic system.

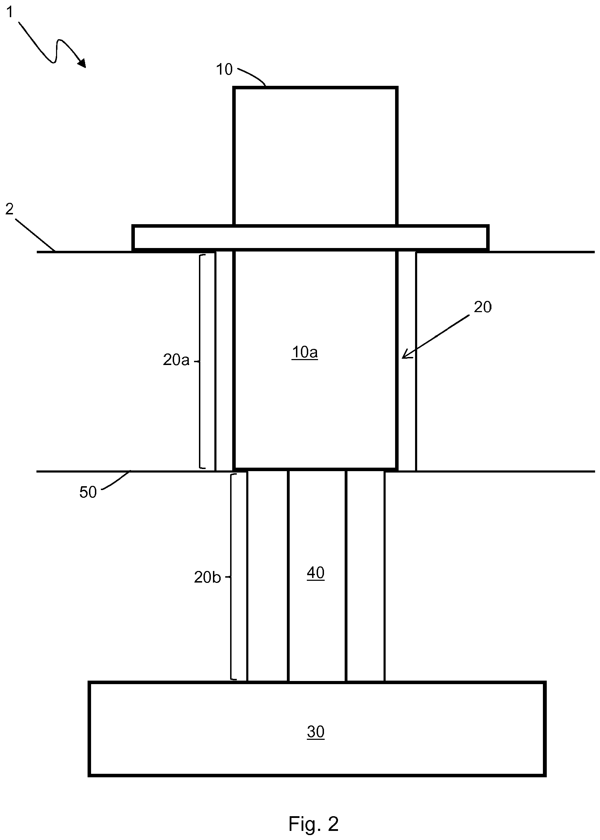

According to this embodiment, a single stage cryocooler is coupled to the target member of a cryogenic system (S101). This is achieved by placing a single-stage cryocooler 10 in a port 20 in a cryostat 2 (see Fig. 2). To couple the single-stage cryocooler to the target member 30, a thermally conductive element 40, which can be made of, for example high conductivity copper, is attached between the single-stage cryocooler 10 and the target member 30. In addition to the coupling to the target member, the single stage cryocooler may also be coupled to a radiation shield 50, which allows the single stage cryocooler to cool the radiation shield 50 at the same time as it cools the target member 30.

To achieve the coupling between the single-stage cryocooler and the target member, there is usually a pressed contact between a copper pad on an end of the cryocooler in contact with the target member and a similar part on the target member. The contact force is applied by external bolts applying pressure to the whole single-stage cryocooler. It is also possible to improve the contact between the cryocooler and the target member by gold plating the copper contact pad, or by using an indium gasket or thermal grease.

Once coupled to the target member, the single-stage cryocooler 10 cools the target member 30 from an initial temperature to a first temperature (S102). The initial temperature will usually be the ambient temperature around the cryogenic system 1, as there is unlikely to have been precooling of the target member. It will therefore be in thermal equilibrium with the environment around the cryogenic system. The first temperature may, for example, be between 20K and 100K. This could be at a temperature greater than 80K to minimise the contamination risk due to condensed air, or could be around 25K to 40K where a two-stage cryocooler will typically have a cooling power that exceeds the cooling power of a single-stage cryocooler.
The temperature of the target member 30 may be directly monitored, or, since the cooling power of the single-stage cryocooler will be known, the temperature of the target member can be calculated based on the properties of the target member, such as the heat capacity, mass and/or the thermal conductivity cryostat performance, and the time spent cooling the target member.

Upon reaching the first temperature, the single-stage cryocooler is removed from the cryogenic system (S103). This is achieved by detaching the single-stage cryocooler 10 from the target member 30, and removing it from the port in the cryogenic system 1. If the single-stage cryocooler is also attached to the radiation shield 50, the single stage cryocooler will also need to be detached from the radiation shield.

As soon as the single-stage cryocooler stops cooling, the target member (and the radiation shields) will begin to heat up. As such, once the single-stage cryocooler is removed from the cryogenic system, there is a need to begin cooling again as quickly as possible.

Upon removal of the single-stage cryocooler, a two-stage cryocooler is coupled to the target member (S104). In addition, the first cooled stage of the two-stage cryocooler may also be coupled to the radiation shield 50.

To slow the rate of warming, the exchange of the single-stage cryocooler with the two-stage cryocooler is conducted as quickly as possible. The exchange could be conducted within a helium atmosphere, for example by placing a "glove bag" containing helium over the devices during the exchange. Alternatively, or additionally, a positive pressure of helium gas can be maintained within the cryogenic system and/or the exchange can be performed at a temperature above the condensation temperature of air.

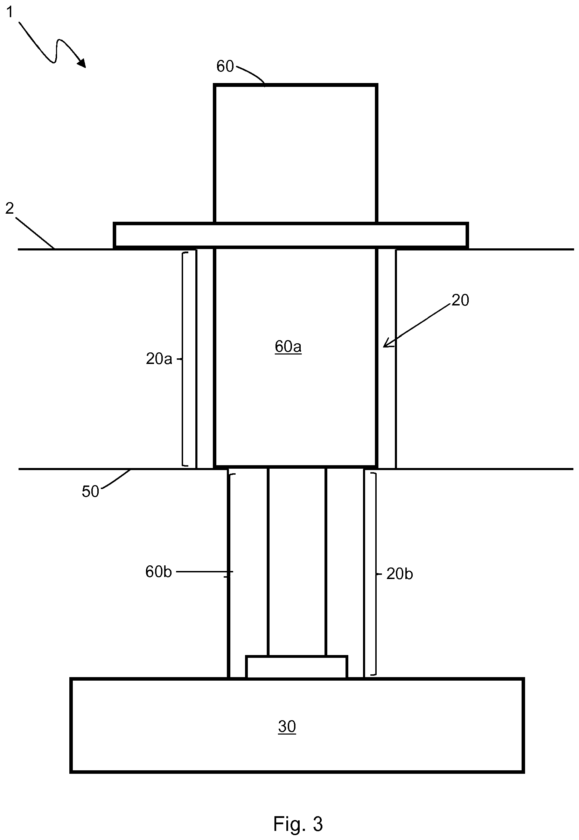

Although the coupling of the two-stage cryocooler is similar to that of the single-stage cryocooler, there are some differences in the coupling. As shown in Fig. 2 and Fig. 3, the port 20 has a wider bore 20a between the exterior of the cryogenic system 1 and the radiation shield 50, and a narrower bore 20b between the radiation shield 50 and the target member 30. As shown in Fig. 2, when located in the port, the cooling stage 10a of the single-stage cryocooler is located in the wider bore 20a of the port, and does not extend down into the narrower bore 20b between the radiation shield 50 and the target member 30. The thermally conducting element 40 extends between the single-stage cryocooler 10 and the target member 30. In contrast to this, as is shown in Fig. 3, when located in the port 20, the two-stage cryocooler 60 has a first stage 60a, which is located in the wider bore 20a of the port, and a second stage 60b located in the narrower bore 20b of the port. The first stage 60a will usually have a cooling power of between 30 to 60 Watts (W), and the second stage 60b will usually have a cooling power between 1 and 2W. Example cooling powers for different two-stage cryocoolers operating at a frequency of 50Hz are 40W at 43K and 1W at 4.2K, 35W at 50K and 1.5W at 4.2K, 45W at 45K and 1W at 4.2K, and 35W at 45K and 1W at 4.2K.

The cooling power of a cryocooler (or a particular stage of a cryocooler) is temperature dependent, and therefore at particular transient or non-base temperatures, the cooling power of a cryocooler (or a particular stage of a cryocooler) may extend outside of the ranges given. For example, the second stage of the two-stage cryocooler will likely have a cooling power outside of the cooling power range given above, when operating at a temperature similar to the base temperature of the first stage (e.g. 40K).

By having a two-stage cryocooler, cooling power of the first stage has to be sacrificed in order to allow the second stage to have sufficient cooling power. Therefore, the single-stage cryocooler 10 will likely have about three times the cooling power of the first stage 60a of the two-stage cryocooler 60. From this, it can be seen that the cooling provided by the single-stage cryocooler in a given period at the first temperature will be much greater than the cooling offered by the first stage of the two-stage cryocooler over the same period. It is somewhat constitutive for a person managing the cooling of the cryogenic system replace a first cryocooler with a second during a cooling cycle, as the cooling must be halted and time taken to replace one cryocooler with another. Furthermore, using only a single cryocooler to cool the target member of a cryogenic system is simpler and poses less of a risk of encountering problems to an operator and to the cryogenic system. Nevertheless, we have realised that the cooling performance difference for the system as a whole outweighs these factors

As shown in Fig. 2, the two-stage cryocooler 60 may be directly coupled to the target member 30. This can be done by direct contact between the second stage 60b and the target member 30. Alternatively, it is possible to have a thermally conductive element between the second stage 60b and the target member 30.

Once coupled to the target member, a two-stage cryocooler is used to cool the target member from its current temperature (i.e, from approximately the first temperature) to an operating temperature (S105). The operational temperature may be between 3K and 20K, such as 4.2K. For example, 4.2K is used when the target member is a superconducting magnet made with Niobium-Titanium wire. However, when Niobium-Tin wire is used for a superconducting magnet acting as the target member, this temperature may be higher.

As with the single-stage cryocooler, the two-stage cryocooler 60 is also able to cool the radiation shield 50 at the same time as cooling the target member. This is due to a thermally conductive coupling between the first stage of the two-stage cryocooler and the radiation shield. Of course, should there be more than one radiation shield, the single-stage cryocooler, and the two-stage cryocooler may be able to cool only one radiation shield, or may be able to cool multiple radiation shields.

Upon reaching the operational temperature, the two-stage cryocooler is used to maintain the temperature of the target member at or below the operational temperature. As such, the two-stage cryocooler is usually not removed from a cryogenic system. However, this can be performed if needed or wanted, e.g. for servicing of the cryocooler or replacement in the event of failure.

As an alternative embodiment, instead of using the thermally conducting element 40 as the link between the single-stage cryocooler and the target member 30, a cold finger is located between the single-stage cryocooler and the target member. The cold finger may contain liquid Helium that boils off on contact with the interior of a lower surface of cold finger that is in contact with the target member, and condenses on the interior of an upper surface of the cold finger, which is in contact with the single-stage cryocooler.

As a further alternative, the single-stage cryocooler can be replaced with a cold finger fed with Helium from an external Helium reservoir. This will remove heat from the cryostat be direct contact between the cold finger and the target member. By pumping Helium in a loop from the external reservoir, which will be cooled, and the cold finger, the target member may be cooled as is achieved with the single-stage cryocooler. It is also possible to attach a heat exchanger to the interface, which removes heat from the target member through the port by means of being supplied with precooled cooling fluid from an external cooling source.

## Claims

1. A method of accelerating cool down of a target member (30) of a cryogenic system (2) to a cryogenic operating temperature, comprising the steps:
cooling a target region of a cryogenic system with a first cooling apparatus (10), the first cooling apparatus being adapted to cool the target region to a first temperature by thermal conduction between the first apparatus and the target member, and having a first cooling power at the first temperature;
replacing the first cooling apparatus with a cryocooler (20) when the target region is at the first temperature; and
cooling the target member of the cryogenic system from the first temperature to an operating temperature using the cryocooler (step S105), wherein
the first cooling power of the first cooling apparatus at the first temperature is greater than the cooling power of the cryocooler at the first temperature.

2. The method according to claim 1, wherein the first cooling apparatus (10) also cools at least one radiation shield (50) by thermal conduction when cooling the target member, the at least one radiation shield being located between the target member (30) and an exterior of the cryogenic system (2).

3. The method according to any one of the preceding claims, wherein the cryocooler (20) is a two-stage cryocooler.

4. The method according to any one of the preceding claims, wherein first cooling apparatus (10) is a single-stage cryocooler.

5. The method according to claim 4, wherein a heat conductive member (40) is attached to the single-stage cryocooler and the target member (30).

6. The method according to any one of claims 1 to 3, wherein the first cooling apparatus (10) includes a conduit and a heat exchanger and wherein a cooling fluid is provided to the heat exchange through the conduit from an external cooling apparatus.

## Patentansprüche

1. Verfahren zum Beschleunigen der Abkühlung eines Zielelements (30) eines kryogenen Systems (2) auf eine kryogene Betriebstemperatur, umfassend die Schritte:
Kühlen einer Zielregion eines kryogenen Systems mit einer ersten Kühleinrichtung (10), wobei die erste Kühleinrichtung derart ausgelegt ist, dass sie die Zielregion durch Wärmeleitung zwischen der ersten Einrichtung und dem Zielelement auf eine erste Temperatur kühlt, und eine erste Kühlleistung bei der ersten Temperatur aufweist;
Ersetzen der ersten Kühleinrichtung durch einen Kryokühler (20), wenn die Zielregion auf der ersten Temperatur ist; und
Kühlen des Zielelements des kryogenen Systems von der ersten Temperatur auf eine Betriebstemperatur unter Verwendung des Kryokühlers (Schritt S105),
wobei
die erste Kühlleistung der ersten Kühleinrichtung bei der ersten Temperatur größer ist als die Kühlleistung des Kryokühlers bei der ersten Temperatur.

2. Verfahren nach Anspruch 1, wobei die Kühleinrichtung (10) bei der Kühlung des Zielelements ebenso wenigstens einen Strahlungsschild (50) durch Wärmeleitung kühlt, wobei sich der wenigstens eine Strahlungsschild zwischen dem Zielelement (30) und einer Außenseite des kryogenen Systems (2) befindet.

3. Verfahren nach einem der vorhergehenden Ansprüche, wobei der Kryokühler (20) ein zweistufiger Kryokühler ist.

4. Verfahren nach einem der vorangehenden Ansprüche, wobei die erste Kühleinrichtung (10) ein einstufiger Kryokühler ist.

5. Verfahren nach Anspruch 4, wobei ein wärmeleitendes Element (40) an dem einstufigen Kryokühler und dem Zielelement (30) angebracht ist.

6. Verfahren nach einem der Ansprüche 1 bis 3, wobei die erste Kühleinrichtung (10) eine Leitung und einen Wärmetauscher beinhaltet und wobei ein Kühlfluid dem Wärmetauscher durch die Leitung von einer externen Kühleinrichtung bereitgestellt wird.

## Revendications

1. Procédé permettant d'accélérer le refroidissement d'un élément cible (30) d'un système cryogénique (2) à une température de fonctionnement cryogénique, comprenant les étapes consistant à :
refroidir une région cible d'un système cryogénique avec un premier appareil de refroidissement (10), le premier appareil de refroidissement étant adapté pour refroidir la région cible à une première température par conduction thermique entre le premier appareil et l'élément cible, et ayant une première puissance de refroidissement à la première température ;
remplacer le premier appareil de refroidissement par un cryorefroidisseur (20) quand la région cible est à la première température ; et
refroidir l'élément cible du système cryogénique de la première température à une température de fonctionnement en utilisant le cryorefroidisseur (étape S105),
dans lequel la première puissance de refroidissement du premier appareil de refroidissement à la première température est supérieure à la puissance de refroidissement du cryorefroidisseur à la première température.

2. Procédé selon la revendication 1, dans lequel le premier appareil de refroidissement (10) refroidit aussi un ou plusieurs écrans anti-rayonnement (50) par conduction thermique lors du refroidissement de l'élément cible, le ou les écrans anti-rayonnement étant situés entre l'élément cible (30) et une partie extérieure du système cryogénique (2).

3. Procédé selon l'une quelconque des revendications précédentes, dans lequel le cryorefroidisseur (20) est un cryorefroidisseur à deux étages.

4. Procédé selon l'une quelconque des revendications précédentes, dans lequel le premier appareil de refroidissement (10) est un cryorefroidisseur à un seul étage.

5. Procédé selon la revendication 4, dans lequel un élément thermoconducteur (40) est fixé au cryorefroidisseur à un seul étage et à l'élément cible (30).

6. Procédé selon l'une quelconque des revendications 1 à 3, dans lequel le premier appareil de refroidissement (10) inclut un conduit et un échangeur de chaleur et dans lequel un fluide de refroidissement est fourni à l'échangeur de chaleur par le conduit depuis un appareil de refroidissement externe.
